Europäisches Patentamt

(19) European Patent Office (11) Publication number: **0 155 853**

Office européen des brevets **B1**

—⑫—

# EUROPEAN PATENT SPECIFICATION

(45) Date of publication of patent specification: **09.01.91** (51) Int. Cl.⁵: **H 01 S 3/19**, H 01 S 3/05

(21) Application number: **85301977.6**

(22) Date of filing: **21.03.85**

(60) Divisional application 90107944.2 filed on 21/03/85.

(54) Window vsis semiconductor laser.

| | |
|---|---|
| (30) Priority: **21.03.84 JP 55048/84**<br>**21.03.84 JP 55049/84** | (73) Proprietor: **SHARP KABUSHIKI KAISHA**<br>**22-22 Nagaike-cho Abeno-ku**<br>**Osaka 545 (JP)** |
| (43) Date of publication of application:<br>**25.09.85 Bulletin 85/39** | (72) Inventor: **Yano, Seiki**<br>**126-80 Toyoda-cho**<br>**Kashihara-shi Nara-ken (JP)**<br>Inventor: **Yamamoto, Saburo**<br>**2-11 Akanedai 1-chome**<br>**Haibara-cho Uda-gun Nara-ken (JP)**<br>Inventor: **Hayashi, Hiroshi**<br>**5-8 Nagamodai 11-chome**<br>**Kamo-cho Soraku-gun Kyoto-fu (JP)**<br>Inventor: **Morimoto, Taiji**<br>**989-4 Hokkeji Shinmachi**<br>**Nara-shi Nara-ken (JP)** |
| (45) Publication of the grant of the patent:<br>**09.01.91 Bulletin 91/02** | |
| (84) Designated Contracting States:<br>**DE GB NL** | |
| (56) References cited:<br>**EP-A-0 095 826**<br>**US-A-4 416 011** | (74) Representative: **Wright, Peter David John et al**<br>**R.G.C. Jenkins & Co. 26 Caxton Street**<br>**London SW1H 0RJ (GB)** |
| **APPLIED PHYSICS LETTERS, vol. 40, no. 5, 1st March 1982, pages 372-374, American Institute of Physics, New York, US; S. YAMAMOTO et al.: "Visible GaAlAs V-channeled substrate inner stripe laser with stabilized mode using ro-GaAs substrate"** | (56) References cited:<br>**IEEE JOURNAL OF QUANTUM ELECTRONICS, vol. QE-19, no. 10, October 1983, pages 1530-1536, IEEE, New York, US; T. HAYAKAWA et al.: "Mode characteristics of large-optical-cavity V-channeled substrate inner stripe injection lasers"** |

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention relates to a window V-channeled substrate inner stripe (referred to as VSIS hereinafter) laser.

A paper entitled "Visible GaAlAs V-Channeled Substrate Inner Stripe Laser With Stabilised Mode Using p-GaAs Substrate" appearing in Applied Physics Letter, Vol. 40, No. 5, March 1982, pages 372—374, AIP, New York, US, by S. Yamamoto et. al. describes a laser of this kind, in which the current is perfectly confined in the V-channel by the inner stripe, and fundamental transverse and single longitudinal mode operation is obtained because the built-in optical waveguide is formed within the V-channel. This laser structure does not have window regions.

A window VSIS laser is proposed in, for example, our published European Patent Application No. 0095826. The conventional window VSIS laser does not show a smooth mode conversion between the window region having a plane active layer, and a stimulated region having a crescent active layer. Therefore, the operational mode is not stable at a high power operation. Furthermore, it is difficult to accurately control the manufacture of the crescent active layer in the normal liquid phase epitaxial method.

Accordingly, the present invention aims to provide a semiconductor laser which provides a stable operation even at a high power operation, and even when the ambient temperature varies. It also aims to provide a novel window VSIS semiconductor laser structure, which ensures stable manufacturing.

According to the present invention, there is provided a window VSIS semiconductor laser having a stimulated region and respective window regions formed at opposite ends of said stimulated region, comprising:

a substrate;

a V-shaped groove formed in said substrate; and

an active layer formed on said substrate,

characterised in that one edge of said V-shaped groove formed in said stimulated region is aligned with the corresponding edge of said V-shaped groove formed in said window regions, and in that said V-shaped groove formed in said stimulated region is wider than said V-shaped groove formed in said window regions.

The present invention will be better understood from the detailed description given hereinbelow and the accompanying drawings which are given by way of illustration only, and thus are not limitative of the present invention and wherein:

Figure 1 is a plan view of the conventional window VSIS semiconductor laser;

Figure 2 is a sectional view taken along line II—II of Figure 1;

Figure 3 is a sectional view taken along line III—III of Figure 1;

Figure 4 is a plan view of an embodiment of a window VSIS semiconductor laser of the present invention; and

Figure 5 is a graph showing the laser wavelength which varies depending on the operating temperature, in the conventional window VSIS semiconductor laser of Figure 1 and in the window VSIS semiconductor laser of Figure 4.

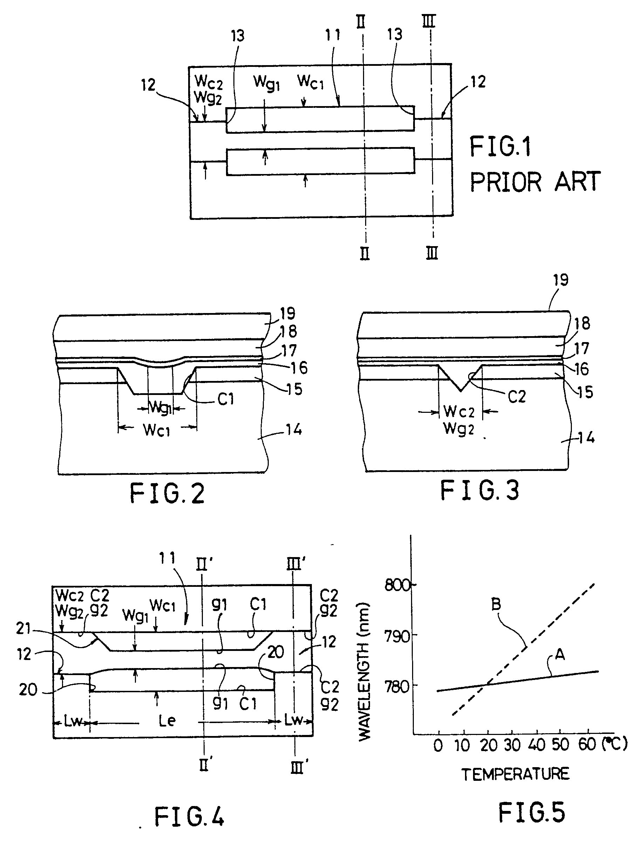

In order to facilitate an understanding of the present invention, an example of the conventional window VSIS semiconductor laser will be first described with reference to Figures 1, 2 and 3. The window VSIS semiconductor laser of Figures 1, 2 and 3 has the same structure as that disclosed in the copending published European Patent Application No. 0095826. Figure 1 is a plan view of the conventional window VSIS semiconductor laser. Figure 2 shows the structure at the stimulated region, and Figure 3 shows the structure at the window region.

The stripe width $W_{c1}$ of a V-shaped groove at a stimulated region 11 is greater than the stripe width $W_{c2}$ of the V-shaped groove in window regions 12. By this structure, an active layer 17 in the stimulated region has the crescent configuration, and the active layer 17 at the window region has the plane configuration. Further, the active layer 17 in the stimulated region is thicker than the active layer 17 in the window region. The thus formed window VSIS semiconductor laser shows the laser emission at the wavelength of 780 nm and at the output power below 120 mW at which the thermal saturation occurs. Further, the window VSIS semiconductor laser of Figure 1 shows a stable fundamental transverse mode below the output power of 60 mW.

In the conventional window VSIS semiconductor laser, the V-shaped groove is not continuous at a boundary 13 provided between the stimulated region 11 and the window region 12. Therefore, the laser beam is reflected at the boundary 13. That is, a smooth mode conversion is not achieved between the stimulated region 11 and the window region 12. This precludes a stable operation at a high power output operation.

Figure 4 shows an embodiment of a window VSIS semiconductor laser of the present invention. The stimulated region (taken along line II'—II') has the similar sectional structure as that disclosed in Figure 2. The window region (taken along line III'—III') has the similar sectional structure as that disclosed in Figure 3.

A V-shaped groove $C_1$ in the stimulated region 11 has a width $W_{c1}$ which is wider than a width $W_{c2}$ of a V-shaped groove $C_2$ in the window regions 12. One edge of the V-shaped groove $C_1$ in the stimulated region is formed at a position where the edge is aligned on the same line with respect to one edge of the V-shaped groove $C_2$ formed in the window region 12. Since the stripe width $W_{c1}$ is wider than the stripe with $W_{c2}$, the remaining edge forms discontinuous boundaries 20 between the stimulated region 11 and the window regions 12. Reference numeral 21 refers to a boundary formed between the stimulated region and the window region at the side where the groove edges are aligned, where the waveguide $g_1$ of the stimulated region is displaced with respect to the waveguide $g_2$ of the window region.

There follows a description of the manufacturing steps of the window VSIS semiconductor laser of Figure 4. Since the section structure is similar to that disclosed in Figures 2 and 3, the explanation is provided with reference to Figures 2, 3 and 4.

An n-GaAs layer 15 (Te-doped concentration $6\times10^{-18}$ cm$^{-3}$) is formed, by the liquid phase epitaxial method, on a p-GaAs substrate 14 (Zn-doped concentration $1\times10^{-19}$ cm$^{-3}$) to have the thickness of about 0.6 microns. The V-shaped groove $(C_1 C_2)$ having the stripe width $W_{c1}$ and $W_{c2}$ is formed in the n-GaAs layer 15 through the use of the photolithography method. In a preferred form, the stimulated region has a length $L_e$ of about 150 microns, and the window region has a length $L_w$ of about 50 microns. The stripe width $W_{c1}$ in the stimulated region is preferably about 6 microns, and the stripe width $W_{c2}$ in the window region is preferably about 3 microns. Therefore, the boundary 20 formed at one edge provided between the stimulated region and the window region has the width of about 3 microns. A p-$Ga_{0.5}Al_{0.5}As$ cladding layer 16, a p-$Ga_{0.85}Al_{0.15}As$ active layer 17, an n-$Ga_{0.5}Al_{0.5}As$ cladding layer 18, and an n-GaAs cap layer 19 are sequentially formed on the n-GaAs layer 15 by the liquid phase epitaxial method. That is, the double-hetero structure is formed. Each layer 16, 17, 18 and 19 has the thickness of about 0.15 microns, 0.1 microns, 1.0 micron and 2.0 microns, respectively, at the plane portion thereof. Electrodes are formed on both sides, and the laser device is formed by cleaving the semiconductor wafer. A waveguide $g_1$ is formed in the stimulated region, and a waveguide $g_2$ is formed in the window region.

Since the one edge of the V-shaped groove is formed continuously between the stimulated region and the window regions, a smooth optical coupling is ensured. A stable oscillation in the fundamental mode is conducted even at a high power output. More specifically, the laser emission in the fundamental mode is ensured at the output of 120 mW. The waveguides $g_1$ and $g_2$ are slightly discontinuous between the stimulated region and the window regions as shown in Figure 4. Accordingly, the window VSIS semiconductor laser of Figure 4 functions as the inner interference type. Therefore, the transverse mode is very stable.

Figure 5 shows the variation of the laser wavelength depending on the temperature variation. The curve A shows the wavelength variation in the window VSIS semiconductor laser of Figure 4. The wavelength varies at the rate of 0.6 Å/°C (1 Å=0.1 nm) when the operating temperature changes from 0°C to 60°C. The curve B shows the wavelength variation in the conventional window VSIS semiconductor laser shown in Figure 1, wherein the wavelength varies at the rate of 3Å/°C.

The invention being thus described, it will be obvious that the same may be varied in many ways without departure from the scope of the invention, which is limited only by the appendant claims.

## Claims

1. A window V-channeled substrate inner stripe (VSIS) semiconductor laser having a stimulated region (11) and respective window regions (12) formed at opposite ends of said stimulated region (11), comprising:

a substrate (14);

a V-shaped groove $(C_1, C_2)$ formed in said substrate (14); and

an active layer (17) formed on said substrate (14),

characterised in that one edge of said V-shaped groove $(C_1)$ formed in said stimulated region is aligned with the corresponding edge of said V-shaped groove $(C_2)$ formed in said window regions, and in that said V-shaped groove $(C_1)$ formed in said stimulated region is wider than said V-shaped groove $(C_2)$ formed in said window regions.

2. A window VSIS semiconductor laser according to claim 1, wherein said active layer (17) has a plane configuration in said window regions, and has a crescent configuration in said stimulated region.

3. A window VSIS semiconductor laser according to claim 1 or claim 2, wherein said active layer (17) is thicker in said stimulated region than in said window regions.

4. A window VSIS semiconductor laser according to any of claims 1 to 3 wherein the other edge of said V-shaped groove $(C_1)$ in said stimulated region forms stepped discontinuous boundaries (20) with the other edge of said V-shaped groove $(C_2)$ in said window regions.

5. A window VSIS semiconductor laser according to any preceding claim, wherein said stimulated region and said window regions have respective waveguides $(g_1, g_2)$ and wherein the waveguide of said stimulated region $(g_1)$ is laterally displaced with respect to the waveguide of said window regions $(g_2)$.

## Patentansprüche

1. V-Kanalsubstrat-Innenstreifen (VSIS) Halbleiterlaser mit Auskopplungsfenster, der einen Anregungsbereich (11) und Auskopplungsbereiche (12) aufweist, die an gegenüberliegenden Seiten des Anregungsbereichs (11) ausgebildet sind, mit

einem Substrat (14),

einem V-förmigen Kanal $(C_1, C_2)$, der in dem Substrat (14) gebildet ist, und

einer aktiven Schicht (17), die auf dem Substrat (14) gebildet ist,

dadurch gekennzeichnet, daß

eine Kante des im Anregungsbereich gebildeten V-förmigen Kanals $(C_1)$ mit der entsprechenden Kante des in den Auskopplungsbereichen gebildeten V-förmigen Kanals $(C_2)$ in einer Geraden ausgerichtet ist, und daß der im Anregungsbereich gebildete V-förmige Kanal (C₁) breiter ist als der in den Auskopplungsbereichen gebildete V-förmige Kanal (C₂).

2. VSIS Halbleiterlaser nach Anspruch 1, wobei die aktive Schicht (17) in den Auskopplungsbereichen in ebener Anordnung und im Anregungsbereich eine sichelförmig gestaltet ist.

3. VSIS Halbleiterlaser nach Anspruch 1 oder 2, wobei die aktive Schicht (17) im Anregungsbereich dicker als in den Auskopplungsbereichen ist.

4. VSIS Halbleiterlaser nach einem der Ansprüche 1 bis 3, wobei die andere Kante des im Anregungsbereich gebildeten V-förmigen Kanals (C₁) einen unstetigen, stufenartigen Übergang (20) mit der anderen Kante des in den Auskopplungsbereichen gebildeten V-förmigen Kanals (C₂) hat.

5. VSIS Halbleiterlaser nach einem der vorhergehenden Ansprüche, wobei der Anregungsbereich und die Auskopplungsbereiche jeweils Wellenleiter (g₁, g₂) aufweisen und wobei der Wellenleiter des Anregungsbereichs (g₁) seitlich gegen den Wellenleiter der Auskopplungsbereiche (g₂) versetzt ist.

**Revendications**

1. Laser à semi-conducteur à fenêtres et à bande intérieure de substrat à rainure en V, comportant une région stimulée (11) et des régions de fenêtre (12) ménagées respectivement aux extrémités opposées de cette région stimulée (11), comprenant:

un substrat (14),

une rainure en V (C₁, C₂) ménagée dans ce substrat (14) et

une couche active (17) disposée sur ce substrat (14),

caractérisé en ce qu'un bord de la rainure en V (C₁) ménagée dans la région stimulée est aligné avec le bord correspondant de la rainure en V (C₂) ménagée dans les régions de fenêtre et en ce que la rainure en V (C₁) ménagée dans la région stimulée est plus large que la rainure en V (C₂) ménagée dans les régions de fenêtre.

2. Laser à semi-conducteur à fenêtres et à bande intérieure de substrat à rainure en V suivant la revendication 1, dans lequel la couche active (17) a une configuration plane dans les régions de fenêtre et a une configuration en croissant dans la région stimulée.

3. Laser à semi-conducteur à fenêtres et à bande intérieure de substrat à rainure en V suivant la revendication 1 ou la revendication 2, dans lequel la couche active (17) est plus épaisse dans la région stimulée que dans les régions de fenêtre.

4. Laser à semi-conducteur à fenêtres et à bande intérieure de substrat à rainure en V suivant l'une quelconque des revendications 1 à 3, dans lequel l'autre bord de la rainure en V (C₁) prévue dans la région stimulée forme des limites discontinues étagées (20) avec l'autre bord de la rainure en V (C₂) prévue dans les régions de fenêtre.

5. Laser à semi-conducteur à fenêtres et à bande intérieure de substrat à rainure en V suivant l'une quelconque des revendications précédentes, dans lequel la région stimulée et les régions de fenêtre ont des guides d'onde respectifs (g₁, g₂) et dans lequel le guide d'onde de la région stimulée (g₁) est décalé latéralement par rapport au guide d'onde des régions de fenêtre (g₂).

FIG.1
PRIOR ART

FIG.2

FIG.3

FIG.4

FIG.5

1